# FASCICULE DE BREVET EUROPEEN

(11) **EP 0 619 647 B1**
(45) Date de publication et mention de la délivrance du brevet: **03.03.1999**
(21) Numéro de dépôt: 94410024.7
(22) Date de dépôt: 06.04.1994
(51) Int. Cl.: H03F 3/45, G05F 3/30

(54) **Architecture d'amplificateur et application à un générateur de tension de bande interdite**
Verstärkerarchitektur und Anwendung zu einem Bandabstandsspannungsgenerator
Amplifier architecture and application for a band gap voltage generator

(30) Priorité: 09.04.1993 FR 9304547
(43) Date de publication de la demande: 12.10.1994
(73) Titulaire: STMicroelectronics S.A., 94250 Gentilly (FR)
(72) Inventeur: Ramet, Serge, F-38100 Grenoble (FR)
(74) Mandataire: de Beaumont, Michel

(56) Documents cités:
- WO-A-92/06424
- US-A- 4 029 974
- US-A- 4 450 367
- IEEE JOURNAL OF SOLID-STATE CIRCUITS., vol.24, no.3, Juin 1989, NEW YORK US pages 690 - 697 M. FERRO ET AL 'A FLOATING CMOS BANDGAP VOLTAGE REFERENCE FOR DIFFERENTIAL APPLICATIONS'
- PATENT ABSTRACTS OF JAPAN vol. 10, no. 154 (P-463) (2210) 4 Juin 1986 & JP-A-61 006 717 (MATSUSHITA DENKI SANGYO K.K.) 13 Janvier 1986

## Description

La présente invention concerne un amplificateur différentiel et l'application d'un tel amplificateur à la réalisation d'un générateur de tension de bande interdite (Band-Gap).

La tension de bande interdite, d'environ 1,2 volts, est une tension indépendante de la température et dont on se sert comme tension de référence dans des applications nécessitant une grande stabilité en température.

Un exemple d'une telle référence est divulgué par le document WO-A-9 206 424.

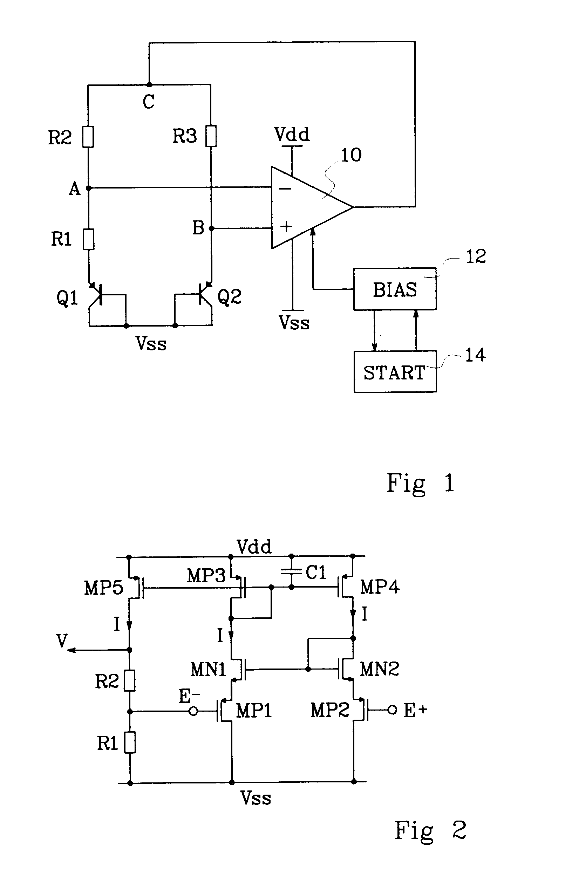

La figure 1 représente un générateur de tension de bande interdite classique tel que décrit, par exemple, dans l'ouvrage "Analysis and Design of Analog Integrated Circuits", par P.R. Gray et R.G. Meyer, Editions John Wiley & Sons.

Un amplificateur opérationnel 10 amplifie la différence de tension entre un noeud A et un noeud B et réinjecte la tension amplifiée sur un noeud C. Le noeud A est relié à un potentiel bas Vss par successivement une résistance R1 et un transistor bipolaire PNP Q1 connecté en diode, et au noeud C par l'intermédiaire d'une résistance R2. Le noeud B est relié au noeud C par l'intermédiaire d'une résistance R3 et au potentiel bas Vss par l'intermédiaire d'un transistor PNP Q2 connecté en diode. La surface d'émetteur du transistor Q1 est supérieure à celle du transistor Q2.

L'amplificateur opérationnel 10, alimenté entre un potentiel haut Vdd et le potentiel bas Vss, agit sur le noeud C afin de maintenir égaux les potentiels des points A et B. Ainsi la tension aux bornes de la résistance R1 est égale à la différence des tensions base-émetteur des transistors Q1 et Q2. Cette différence est proportionnelle à la température absolue et au logarithme népérien du rapport de surface d'émetteur des transistors Q1 et Q2. Cette différence de tension, de coefficient de température positif, apparaît aux bornes de la résistance R2 (entre les noeuds C et A), multipliée par le rapport R2/R1. La tension entre le noeud A et le potentiel Vss est égale à la tension base-émetteur du transistor Q2, qui a un coefficient de température négatif. En choisissant adéquatement le rapport R2/R1, le coefficient de température de la tension résultante entre le noeud C et le potentiel Vss est annulé. Dans ce cas, on trouve entre le noeud C et le potentiel Vss la tension de bande interdite. La valeur de la résistance R3 est choisie égale à celle de la résistance R2.

En technologie bipolaire, il existe des solutions très simples pour réaliser de tels générateurs, notamment l'amplificateur opérationnel 10.

En technologie CMOS, un amplificateur opérationnel satisfaisant à la fonction de l'amplificateur opérationnel 10 de la figure 1 comprend un certain nombre de branches, c'est-à-dire de chemins de courant entre le potentiel haut Vdd et le potentiel bas Vss, qui doivent toutes être polarisées par un générateur de courant. La solution la plus simple pour polariser toutes ces branches consiste à prévoir un générateur de polarisation 12 qui alimente un miroir de courant à plusieurs sorties dont chacune sert à polariser une branche.

Un montage du type de la figure 1, notamment le générateur de polarisation 12, présente un point de fonctionnement stable à courant nul. Ainsi, si aucun courant ne se met à circuler dans le montage dès la mise sous tension, l'amplificateur 10, et par conséquent le générateur de tension, ne démarre pas. Pour éviter cet inconvénient, on prévoit un circuit de démarrage 14 qui a pour rôle de détecter un courant nul dans une branche et d'injecter un courant dans le montage pour faire basculer celui-ci vers un point de fonctionnement à courant non nul.

Un inconvénient des montages du type de la figure 1 en technologie CMOS résulte du fait que les réalisations classiques de l'amplificateur opérationnel 10 impliquent la réalisation d'un grand nombre de branches. La présence d'un grand nombre de branches entraine, d'une part, une complexité élevée du montage et, d'autre part, une consommation particulièrement élevée car, en général, les courants dans les branches sont du même ordre de grandeur.

Un objet de la présente invention est de prévoir un amplificateur opérationnel présentant un nombre de branches particulièrement faible.

Un autre objet de la présente invention est de prévoir un générateur de tension de bande interdite en technologie CMOS présentant un nombre de branches particulièrement faible.

Ces objets sont atteints grâce à un amplificateur différentiel comprenant en série entre des premier et deuxième potentiels d'alimentation des premier à troisième transistors d'un premier type, d'un deuxième type, et du premier type respectivement, les premier et deuxième transistors étant respectivement un transistor d'entrée d'un premier miroir de courant et un transistor de sortie d'un deuxième miroir de courant, l'électrode de commande du troisième transistor formant une entrée inverseuse de l'amplificateur. L'amplificateur comprend aussi, en série entre les premier et deuxième potentiels d'alimentation, des quatrième à sixième transistors des premier, deuxième, et premier type respectivement, les quatrième et cinquième transistors étant respectivement un transistor de sortie du premier miroir et un transistor d'entrée du deuxième miroir, l'électrode de commande du sixième transistor formant une entrée non-inverseuse de l'amplificateur. Le courant de sortie de l'amplificateur est fourni par un septième transistor du premier type qui est un transistor de sortie du premier miroir.

Un générateur de tension de bande interdite selon l'invention comprend l'amplificateur susmentionné. Ce-dernier alimente des premier et deuxième transistors bipolaires de tailles différentes reliés au deuxième potentiel. Ces transistors bipolaires sont reliés à la sortie de l'amplificateur respectivement par un couple de résistances et par une résistance, le point de connexion des résistances du couple de résistances étant relié à l'entrée inverseuse de l'amplificateur, et le point de connexion de ladite résistance et du deuxième transistor bipolaire étant relié à l'entrée non-inverseuse de l'amplificateur.

Selon un mode de réalisation de la présente invention, les troisième et sixième transistors de l'amplificateur sont reliés respectivement aux bases des premier et deuxième transistors bipolaires et au deuxième potentiel par, respectivement, des troisième et quatrième transistors bipolaires, connectés en diode.

Selon un mode de réalisation de la présente invention, le générateur comprend des moyens pour fournir un courant au deuxième miroir si le premier miroir ne fournit aucun courant.

Ces objets, caractéristiques et avantages ainsi que d'autres de la présente invention seront exposés en détail dans la description suivante de modes de réalisation particuliers faite en relation avec les figures jointes parmi lesquelles :
la figure 1, précédemment décrite, représente un générateur classique de tension de bande interdite ;
la figure 2 représente un mode de réalisation en technologie CMOS d'un amplificateur selon la présente invention ;
la figure 3 représente l'amplificateur de la figure 2 inséré dans un générateur de tension de bande interdite ; et
la figure 4 représente un générateur de double tension de bande interdite selon la présente invention.

La figure 2 représente un couple de transistors MOS à canal P MP1 et MP2 dont les grilles constituent respectivement une entrée inverseuse E- et une entrée non-inverseuse E+ d'un amplificateur selon l'invention. Les drains des transistors MP1 et MP2 sont reliés à un potentiel bas Vss et les sources de ces transistors sont respectivement reliées aux sources de transistors MOS à canal N MN1 et MN2. Les drains des transistors MN1 et MN2 sont respectivement reliés aux drains de transistors MOS à canal P MP3 et MP4, eux-mêmes reliés à un potentiel haut Vdd par leurs sources. Le drain du transistor MN2 est relié aux grilles des transistors MN1 et MN2, et le drain du transistor MP3 est relié aux grilles des transistors MP4 et MP3. Un transistor MOS à canal P MP5 est relié en parallèle sur les sources et grilles des transistors MP3 et MP4. La sortie V de l'amplificateur est prélevée sur le drain de ce transistor MP5.

Avec cette configuration, les transistors MP3 et MP4 d'une part et les transistors MN1 et MN2 d'autre part, constituent respectivement deux miroirs de courant connectés tête-bêche. Le courant de drain I du transistor d'entrée, MP3, du premier miroir est recopié sur le drain du transistor de sortie, MP4, de ce miroir. De même, le courant de drain I du transistor d'entrée, MN2, du deuxième miroir est recopié sur le drain du transistor de sortie, MN1, de ce miroir. Le transistor MP5 constitue un deuxième transistor de sortie du premier miroir, et recopie donc sur son drain le courant de drain du transistor d'entrée MP3. Bien entendu, la recopie des courants d'un drain à un autre est effectuée à un coefficient multiplicatif près correspondant au rapport de surface des transistors considérés (par exemple, si le rapport de surface entre le transistor MP5 et MP3 est égal à 2, le courant de drain du transistor MP5 est égal à deux fois celui du transistor MP3).

On a représenté un pont de résistances R1, R2 de contre-réaction de l'amplificateur. La résistance R1 est reliée entre le potentiel Vss et l'entrée E- et la résistance R2 est reliée entre le drain du transistor MP5 (la sortie V) et l'entrée E-.

Le fonctionnement de cet amplificateur est le suivant.

Au repos, on suppose que les tensions E- et E+ sur les bornes E- et E+ sont égales. Il s'établit un courant de repos identique dans chacune des branches, égal à E-/R1 (ou E+/R1), et la tension de sortie V est égale à (1+R2/R1)E-.

Si la tension E+ devient supérieure à la tension E-, la tension grille-source du transistor MN1 augmente. Le transistor MN1 devient plus conducteur et le courant de drain du transistor MP3 augmente. Par l'effet du miroir MP3/MP4, le courant de drain du transistor MP4, et donc celui du transistor MN2, augmente de même. Par l'effet du miroir MN1/MN2, le courant de drain du transistor MN1 augmente encore...

Ce processus ne diverge pas car l'effet de miroir entre les transistors MP3 et MP5 entraîne la recopie de l'accroissement de courant du transistor MP3 dans le transistor MP5, ce qui se traduit par une augmentation de la tension V, et donc de la tension E-. La tension E- augmente jusqu'à ce que les tensions E- et E+ soient égales. On retrouve alors un nouveau courant E-/R1=E+/R1 dans les trois branches.

Si la tension E+ devient inférieure à la tension E-, la tension grille-source du transistor MN1 diminue. Le transistor MN1 devient moins conducteur et le courant de drain du transistor MP3 diminue. Par l'effet du miroir MP3/MP4, le courant de drain du transistor MP4, et donc celui du transistor MN2, diminue de même. Par l'effet du miroir MN1/MN2, le courant de drain du transistor MN1 diminue encore...

Ce processus ne diverge pas car l'effet de contre-réaction, décrit ci-dessus, exercé par le transistor MP5 agit cette fois de façon à abaisser la tension E- de manière à la faire tendre vers la nouvelle valeur de la tension E+.

L'ensemble des transistors MN1, MN2, MP3, MP4 constitue, comme cela vient d'être décrit, une boucle montée en réaction qui est stabilisée par une boucle montée en contre-réaction.

Quelle que soit la valeur de la tension E+, le montage de la figure 2 agit de manière à faire tendre la tension E- vers la tension E+, et donc à faire tendre la tension de sortie V vers la valeur (1+R2/R1)E+. Le montage se comporte comme un amplificateur de gain (V/E+) égal à 1+R2/R1.

L'amplificateur selon l'invention présente la particularité d'être auto-polarisé (c'est-à-dire qu'il ne requiert pas d'étage de polarisation) et d'avoir un nombre de branches particulièrement faible (trois).

Pour améliorer la stabilité de l'amplificateur, on peut prévoir une capacité C1 (de l'ordre de 25 pF, par exemple) connectée entre le potentiel Vdd et les grilles des transistors MP3 et MP4.

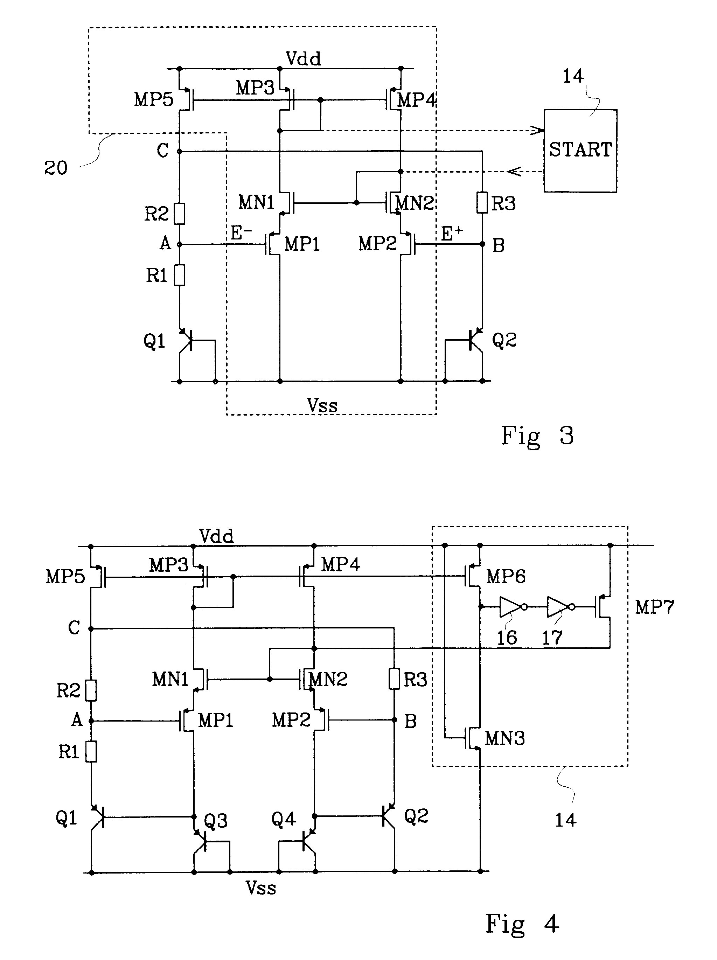

La figure 3 représente un générateur de tension de bande interdite selon la présente invention. Ce générateur est obtenu en remplaçant l'amplificateur 10 de la figure 1 par l'amplificateur selon l'invention désigné par la référence 20. Les noeuds A et B (figure 1) sont reliés respectivement aux bornes E- et E+ de l'amplificateur selon l'invention. Le drain du transistor de sortie MP5 est relié au noeud C. Il est prévu un dispositif de démarrage 14 mesurant le courant dans les transistors MP3 et MP4 pour injecter un courant à l'entrée du miroir MN1/MN2. Une fois que le circuit de la figure 3 atteint un point de fonctionnement à courant non nul, le dispositif 14 ne consomme plus qu'un courant résiduel (un exemple de dispositif de démarrage 14 est représenté à la figure 4 décrite ci-après).

Un générateur de tension de bande interdite selon l'invention, en technologie CMOS, présente seulement quatre branches consommatrices de courant, à savoir les branches comprenant respectivement les transistors Q1 et Q2, et les branches comprenant respectivement les transistors MP1 et MP2 de l'amplificateur.

La figure 4 représente un mode de réalisation de générateur de double tension de bande interdite utilisant un amplificateur selon l'invention. Des mêmes éléments qu'à la figure 3 sont désignés par des mêmes références. Les transistors MP1 et MP2, au lieu d'être reliés directement au potentiel bas Vss, y sont reliés respectivement par des transistors PNP Q3 et Q4 connectés en diode. Les bases des transistors Q1 et Q2, au lieu d'être reliées au potentiel bas Vss sont reliées respectivement aux émetteurs des transistors Q3 et Q4.

Ce générateur permet d'obtenir entre le noeud C et le potentiel bas Vss deux fois la tension de bande interdite avec seulement deux transistors bipolaires de plus que pour obtenir une tension de bande interdite ; alors qu'il fallait classiquement pratiquement doubler le nombre de composants du circuit de la figure 1.

L'avantage de produire une tension de référence deux fois plus élevée, comme le générateur de la figure 4, est que l'on diminue l'influence d'un décalage de tension parasite (offset) induit par l'amplificateur (dû, par exemple, à un mauvais appariement des transistors de l'amplificateur).

De nombreux autres moyens sont connus pour diminuer les effets de cette tension de décalage. Par exemple, les rôles des transistors de la branche MP3, MN1, MP1 peuvent être périodiquement intervertis avec les rôles des transistors respectifs de la branche MP4, MN2, MP2 à l'aide d'interrupteurs commutés à fréquence élevée. C'est ce que l'on appelle un amplificateur stabilisé par hachage (Chopper Stabilized Amplifier). Cette solution supprime totalement les effets de la tension de décalage.

A la figure 4, on a représenté plus en détail un exemple de dispositif de démarrage 14. Ce dispositif de démarrage comprend un transistor MOS à canal P MP6 relié en parallèle sur la source et la grille du transistor MP4. Ce transistor MP6 tend à recopier sur son drain le courant de drain du transistor MP4. Le drain du transistor MP6 est relié au potentiel bas Vss par un transistor MOS à canal N MN3 dont la grille est reliée au potentiel haut Vdd. Ainsi, le transistor MN3 est en permanence conducteur. Toutefois, le rapport largeur/longueur (W/L) de canal de ce transistor est choisi très faible, ce qui entraîne que ce transistor se comporte comme une résistance de valeur très importante. Le point de connexion entre les transistors MP6 et MN3 est relié à l'entrée d'un amplificateur de courant formé de deux inverseurs 16 et 17 reliés en série. L'inverseur 17 commande la grille d'un transistor MOS à canal P MP7 relié entre le potentiel haut Vdd et le drain du transistor MN2.

Si aucun courant ne circule dans le transistor MP4 (ou dans le transistor MP3), le transistor MP6 est bloqué. La tension d'entrée de l'inverseur 16 est tirée vers le potentiel bas Vss par le transistor MN3. Le transistor MP7 devient conducteur et injecte un courant dans le drain du transistor MN2, ce qui active le miroir MN1/MN2. Le courant s'établit dans les deux branches de l'amplificateur et le transistor MP6 devient conducteur. L'entrée de l'inverseur 16 est tirée vers le potentiel haut Vdd et le transistor MP7 est bloqué. Seulement un très faible courant est consommé dans la branche comprenant les transistors MP6 et MN3, car le transistor MN3 se comporte comme une résistance de forte valeur.

On donne, à titre d'exemple, des valeurs de rapports W/L utilisés pour un générateur consommant 50 microampères avec R2=R3 = 52500 ohms et R1 = 5320 ohms :

| transistors | W/L |
|---|---|
| MP1, MP2, MN1, MN2 | 240um/6um |
| MP3, MP4 | 60um/12um |
| MP5 | 120um/12um |
| MN3 | 1,5um/56um |
| MP6 | 24um/1,2um |
| MP7 | 6um/1,2um |

(les lettres "um" désignent un micromètre).

De nombreuses variantes et modifications de la présente invention apparaîtront à l'homme du métier. Notamment, on a décrit une structure d'amplificateur en technologie CMOS adaptée à la réalisation, en technologie CMOS, d'un générateur de tension de référence comportant un nombre minimum de branches. Toutefois, l'invention consiste essentiellement en la structure à faible nombre de branches de l'amplificateur lui-même, qui peut être transposée en technologie bipolaire.

## Revendications

1. Amplificateur différentiel caractérisé en ce qu'il comprend en série entre des premier et deuxième potentiels d'alimentation (Vdd, Vss) :
- successivement des premier à troisième transistors (MP3, MN1, MP1) d'un premier type (P), d'un deuxième type (N), et du premier type (P) respectivement, les premier (MP3) et deuxième (MN1) transistors étant respectivement un transistor d'entrée d'un premier miroir de courant et un transistor de sortie d'un deuxième miroir de courant, l'électrode de commande du troisième transistor formant une entrée inverseuse (E-) de l'amplificateur ;
- successivement des quatrième à sixième transistors (MP4, MN2, MP2) des premier, deuxième, et premier type respectivement, reliés en série comme les premier à troisième transistors, les quatrième (MP4) et cinquième (MN2) transistors étant respectivement un transistor de sortie du premier miroir et un transistor d'entrée du deuxième miroir, l'électrode de commande du sixième transistor formant une entrée non-inverseuse (E+) de l'amplificateur ;
et en ce que le courant de sortie de l'amplificateur est fourni par un septième transistor (MP5) du premier type qui est un transistor de sortie du premier miroir, les branches comprenant les premiers à troisième transistors (MP3, MN1, MP1) et les quatrième à sixième transistors (MP4, MN2, MP2) étant symétriques et comprenant le même nombre d'éléments.

2. Amplificateur selon le revendication 1, caractérisé en ce que le premier type est MOS à canal P et le deuxième type est MOS à canal N.

3. Générateur de tension de bande interdite, caractérisé en ce qu'il comprend un amplificateur selon la revendication 1, alimentant des premier et deuxième transistors bipolaires (Q1, Q2) de tailles différentes reliés au deuxième potentiel (Vss), ces transistors bipolaires étant reliés à la sortie de l'amplificateur respectivement par un couple de résistances (R2, R1) et par une résistance (R3), le point de connexion (A) des résistances du couple de résistances étant relié à l'entrée inverseuse (E-) de l'amplificateur, et le point de connexion de ladite résistance et du deuxième transistor bipolaire (Q2) étant relié à l'entrée non-inverseuse de l'amplificateur.

4. Générateur de double tension de bande interdite selon la revendication 3, caractérisé en ce que les troisième (MP1) et sixième (MP2) transistors de l'amplificateur sont reliés respectivement aux bases des premier (Q1) et deuxième (Q2) transistors bipolaires et au deuxième potentiel par, respectivement, des troisième (Q3) et quatrième (Q4) transistors bipolaires, connectés en diode.

5. Générateur selon l'une des revendications 3 et 4, caractérisé en ce qu'il comprend des moyens (14) pour fournir un courant au deuxième miroir si le premier miroir ne fournit aucun courant.

## Patentansprüche

1. Differenzverstärker, dadurch gekennzeichnet, daß er in Reihe zwischen einem ersten und einem zweiten Speisepotential (Vdd, Vss) aufweist:
- aufeinanderfolgend je einen ersten bis dritten Transistor (MP3, MN1, MP1) eines ersten Typs (P), eines zweiten Typs (N) bzw. des ersten Typs (P), wobei der erste (MP3) bzw. der zweite (MN1) Transistor ein Eingangstransistor eines ersten Stromspiegels bzw. ein Ausgangstransistor eines zweiten Stromspiegels sind und die Steuerelektrode des dritten Transistors einen invertierenden Eingang (E-) des Verstärkers bildet;
- aufeinanderfolgend je einen vierten bis sechsten Transistor (MP4, MN2, MP2) vom ersten, zweiten bzw.ersten Typ, in Reihenschaltung wie der erste bis dritte Transistor, wobei der vierte (MP4) bzw. der fünfte (MN2) Transistor ein Ausgangstransistor des ersten Spiegels bzw. ein Eingangstransistor des zweiten Spiegels sind und die Steuerelektrode des sechsten Transistors einen nicht-invertierenden Eingang (E+) des Verstärkers bildet;
- weiter dadurch gekennzeichnet, daß der Ausgangsstrom des Verstärkers von einem siebenten Transistor (MP5) des ersten Typs geliefert wird, der ein Ausgangstransistor des ersten Spiegels ist, wobei die den ersten bis dritten Transistor (MP3, MN1, MP1) bzw. den vierten bis sechsten Transistor (MP4, MN2, MP2) enthaltenden Zweige symmetrisch sind und die gleiche Anzahl von Elementen umfassen.

2. Verstärker nach Anspruch 1, dadurch gekennzeichnet, daß der erste Typ P-Kanal MOS und der zweite Typ N-Kanal MOS ist.

3. Band-gap -Spannungsgenerator, dadurch gekennzeichnet, daß er einen Verstärker nach Anspruch 1 umfaßt zur Speisung eines ersten und eines zweiten Bipolartransistors (Q1, Q2) unterschiedlicher Größe, die mit dem zweiten Potential (Vss) verbunden sind, daß diese Bipolar-Transistoren mit dem Ausgang des Verstärkers über ein Paar von Widerständen (R2, R1) bzw. über einen Widerstand (R3) verbunden sind, und daß der Verbindungs- bzw. Knotenpunkt (A) des Widerstandspaars mit dem invertierenden Eingang (E-) des Verstärkers und der Verbindungs- bzw. Knotenpunkt des genannten Widerstands und des zweiten Bipolartransistors (Q2) mit dem nicht-invertierenden Eingang (E+) des Verstärkers verbunden sind.

4. Generator für die doppelte band-gap - Spannung nach Anspruch 2, dadurch gekennzeichnet, daß der dritte (MP1) bzw. der sechste (MP2) Transistor des Verstärkers mit den Basisanschlüssen des ersten (Q1) bzw. des zweiten (Q2) Bipolartransistors, und mit dem zweiten Potential (Vss) über einen dritten (Q3) bzw. einen vierten (Q4) Bipolartransistor, die jeweils als Diode geschaltet sind, verbunden sind.

5. Generator nach einem der Ansprüche 3 und 4, dadurch gekennzeichnet, daß er Mittel (14) aufweist, welche dem zweiten Spiegel Strom zuführen, wenn der erste Spiegel keinen Strom liefert.

## Claims

1. A differential amplifier characterized in that it includes in series between first and second supply voltages (Vdd, Vss):
- successively first to third transistors (MN3, MN1, MP1) of a first type (P), of a second type (N), and of the first type (P), respectively, the first transistor (MP3) being an input transistor of a first current mirror, the second transistor (MN1) being an output transistor of a second current mirror, the control electrode of the third transistor forming an inverting input (E-) of the amplifier;
- successively fourth to sixth transistors (MP4, MN2, MP2) of the first, second, and first type, respectively, the fourth transistor (MP4) being an output transistor of the first current mirror, the fifth transistor (MN2) being an input transistor of the second current mirror, the control electrode of the sixth transistor forming a non-inverting input (E+) of the amplifier;
and in that the amplifier output current is provided by a seventh transistor (MP5) of the first type that is an output transistor of the first current mirror, the branches including the first to third transistors (MP3, MN1, MP1) and the fourth to sixth transistors (MP4, MN2, MP2) being symmetrical and including the same number of elements.

2. The amplifier of claim 1, wherein the first type is P-channel MOS and the second type is N-channel MOS.

3. A band-gap voltage generator including an amplifier according to claim 1, supplying first and second bipolar transistors (Q1, Q2) of dissimilar sizes connected to the second voltage (Vss), said bipolar transistors being connected to the amplifier output through a pair of resistors (R2, R1) and through a resistor (R3), respectively, the connection point (A) between the resistors of the pair of resistors being connected to the inverting input (E-) of the amplifier, and the connection point between the single resistor and the second bipolar transistor (Q2) being connected to the non-inverting input of the amplifier.

4. A double band-gap voltage generator according to claim 3, wherein the third (MP1) and sixth (MP2) transistors of the amplifier are respectively connected to the bases of the first (Q1) and second (Q2) bipolar transistors and to the second voltage through, respectively, third (Q3) and fourth (Q4) diode-connected bipolar transistors.

5. The generator of claim 3 or 4, including means (14) for providing a current to the second current mirror if the first current mirror does not provide current.
